# EUROPEAN PATENT SPECIFICATION

(11) **EP 1 530 802 B1**
(45) Date of publication and mention of the grant of the patent: **12.06.2013**
(21) Application number: 03740942.2
(22) Date of filing: 01.07.2003
(51) Int. Cl.: H01L 23/544

(54) **INTEGRATED CIRCUIT WITH ID CODE AND METHOD OF MANUFACTURING SAME**
INTEGRIERTE SCHALTUNG MIT IDENTIFIZIERUNGSCODE UND VERFAHREN ZU IHRER HERSTELLUNG
CIRCUIT INTEGRE ET SON PROCEDE DE FABRICATION

(30) Priority: 15.08.2002 EP 02078381
(43) Date of publication of application: 18.05.2005
(73) Proprietor: NXP B.V., 5656 AG Eindhoven (NL)
(72) Inventor: HEESSELS, Adrianus, C., L., NL-5656 AA Eindhoven (NL)
(74) Representative: Schouten, Marcus Maria
(86) International application number: PCT/IB2003/003033
(87) International publication number: WO 2004/017408

(56) References cited:
- WO-A-02/45139
- DE-A- 10 025 213
- US-A- 6 161 213
- US-A1- 2002 024 453

## Description

The invention relates to an integrated circuit (IC) comprising a set of cells, each cell comprising an electrical device having a device parameter with a parameter value which is a function of random parametric variations, the set of cells comprising a first subset of identification (ID) cells, and a second subset of cells for generating an ID code by measuring the parameter values of the ID cells.

The invention also relates to a method for manufacturing such an IC, the IC comprising a substrate and a set of cells, each cell comprising an electrical device having a device parameter with a parameter value which is a function of random parametric variations, the substrate comprising a first portion and a second portion, the method comprising a step which causes the random parametric variations.

US-6,161,213 discloses an embodiment of an IC described in the opening paragraph. The IC comprises an array of identically designed ID cells each of which is a transistor circuit with two transistors. The transistor circuit produces a pair of currents whose difference is influenced by random parametric variations affecting the operating characteristics of the transistors forming the ID cell. These random parametric variations are used to generate an ID code.

The IC further comprises a measurement circuit for sequentially accessing each ID cell of the array to measure this difference. The results of these measurements are encoded into a single output. This output comprises an ID code, which is unique to that particular combination of measurements. Provided the array of ID cells is large enough, there is a low probability that the array in any one IC will produce the same combination of measurements as an array in any of a large number of other ICs. Therefore, the ID code can be used as an ID number for each chip.

The measurement circuit comprises a load circuit, which converts the two currents produced by the transistors of an ID cell into two voltages. It provides the difference between these two voltages as a cell output. For the conversion of the two currents into the two voltages, two load cells with transistors similar to the transistors in the ID cells are used as load resistors. Mismatches in the load resistors and in the circuitry connecting the ID cells and the load circuit cause a constant voltage offset which adds to the cell output, resulting in an effective cell output.

When the constant voltage offset exceeds the cell output, the effective cell output has a sign determined by the constant voltage offset and an amplitude determined by both the constant voltage offset and the cell output. For encoding the cell outputs it is then not sufficient to monitor the sign of the effective cell output. Therefore, the following measures are taken in the known IC to generate the ID code: (1) the load cells comprise a square array with an equal number of transistors connected in series and in parallel; (2) the measurement circuit comprises an auto-zeroing comparator for comparing the effective cell output of the most recently measured ID cell with that of a previously measured ID cell; when the former effective cell output is larger than the latter, the ID cell measured most recently is assigned to an output "1", otherwise to "0"; and (3) the measurement circuit further comprises an error detection unit.

It is a disadvantage of the known IC that it is relatively difficult to generate an ID code from the measurement of the parameter values, which are a function of the random parametric variations in the ID cells.

It is an object of the invention to provide an IC of the kind described in the opening paragraph, which has a relatively simple design allowing for a relatively easy generation of an ID code from the measurement of the parameter values that are a function of the random parametric variations in the ID cells.

The invention is defined by the independent claims. The dependent claims define advantageous embodiments.

According to the invention the object is realized in that the ID cells have first random parametric variations and the cells of the second subset have second random parametric variations, the first random parametric variations being larger than the second random parametric variations.

Since the beginning of manufacturing ICs there has been a permanent trend to reduce the random parametric variations as much as possible. The known IC makes beneficial use of the remaining random parametric variations to generate an ID code. However, the random parametric variations in the ID cells are substantially the same as those in the rest of the IC, including in particular the second subset, which is used for generating an ID code by measuring the parameter values of the ID cells.

In the known IC the second subset is subjected to the same random parametric variations, as a result of which it introduces a constant offset in the parameter values of the first subset, which is comparable to or even larger than the random differences in the parameter values of the ID cells. In the known IC the generation of the ID code from the measurement of the parameter values, that are a function of the random parametric variations in the ID cells, is therefore relatively difficult and a relatively complicated measurement circuit is required.

In the device according to the invention this disadvantage is overcome by deliberately increasing the random parametric variations in the first subset with respect to those in the second subset, thereby acting against the trend to reduce the random parametric variations as much as possible. As the random parametric variations in the first subset are larger than those in the second subset, the constant offset in effective cell output is small as compared to the random differences in the parameter values, and the generation of the ID code from the measurement of the random parametric variations in the ID cells is relatively easy.

The IC according to the invention has an additional advantage: normally, due to noise and drift in the first subset and/or the second subset, the parameter value of an ID cell as measured by the second subset may randomly change with time, leading to an unpredictable change of the ID code. The chance of such an arbitrary change is reduced according to the invention due to the broader distribution of parameter values, which is an additional advantage.

The ID cells according to the invention may comprise a conventional metal oxide semiconductor field effect transistor (MOSFET) as the electrical device. Alternatively, or in addition to the MOSFET, the electrical device may comprise any other electrical device having a device parameter with a parameter value, which is a function of random parametric variations. It may comprise, e.g. a bipolar transistor, a diode such as, e.g. a Schottky diode, a capacitor, an ohmic resistor or an induction.

Analogous to the prior art, the device parameter according to the invention may comprise a voltage such as, e.g. the threshold voltage of a MOSFET. Alternatively, or in addition to the prior art, the device parameter may comprise a voltage drop across an ohmic resistor, a current such as, e.g. the current provided by a transistor, a charge stored on a capacitor or a resonance frequency of a high frequency circuit comprising an induction.

The random parametric variations may be due to, e.g. a deposition of doping atoms in a substrate, which may modify the threshold voltage of a MOSFET. Alternatively, the doping atoms may be used to control the thickness of an oxide grown on top of the substrate comprising the doping atoms as is described in EP-A1-1,093,667. The oxide may then be covered by another conductive layer to form a capacitor which has a capacitance value that is subjected to random parametric variations. The deposition of doping atoms is subject to random parametric variations because the doping atoms are randomly distributed, resulting in a statistical distribution in the number of doping atoms per unit area as is described in US-6,161,213. Ways to manufacture an IC according to the invention will be described below.

Alternatively, the random parametric variations may be due to a random deposition of magnetic particles in the vicinity of an inductor whose inductance is subjected to these random parametric variations. The differences in induction may be measured by determining the resonance frequency of a circuit comprising the inductance. In general, a small amount of magnetic particles may be present in the ID cells of the first subset and in the cells of the second subset due to, e.g. contamination in the manufacturing equipment, which is usually reduced as much as possible. The amount of particles in the ID cells may be deliberately increased by randomly distributing small magnetic particles over an area in the vicinity of the inductors. This area may be defined, e.g. by a photolithographic mask.

In another embodiment, the random parametric variations may comprise a distribution of deposited metal atoms such as, e.g. titanium or tungsten on polycrystalline silicon to form a silicide, which is an ohmic resistor with a resistance. The ohmic resistor may be, but is not limited to, a part of a transistor, e.g. in the source or the drain region. The resistance is a function of the random parametric variations caused when depositing the metal atoms which form the silicide. In general, there are small variations in the number of atoms deposited per unit area. These variations may have been increased by, e.g. randomly distributing particles over a part of the polycrystalline silicon in the first subset prior to the deposition of the metal atoms.

In yet another embodiment, the random parametric variations may comprise a random distribution of particles which may be electrically insulating or conducting. These particles, which may originate e.g. from contamination present in the manufacturing equipment, are usually reduced as much as possible, but in the IC according to the invention they may have been deliberately introduced in the first subset to randomly create, e.g. short circuits between an electrical device and a ground electrode. Alternatively, or in addition, open circuits in some of the ID cells may have been introduced by insulating particles.

It is particularly advantageous if the first random parametric variations cause random differences among the parameter values of the ID cells, the random differences each having an absolute value, the absolute values having an average value, and the second random parametric variations cause an offset in the parameter values of the ID cells, the offset having an absolute value, the average value being larger than the absolute value of the offset.

In general, the parameter values of the ID cells as measured by the second subset depend on the first random parametric variations, which cause random differences among the parameter values of the ID cells, and on the second random parametric variations, which cause an offset in the measured parameter values of the ID cells. When the average value of the absolute values of the random differences is larger than the absolute value of the offset, it is relatively easy to generate an ID code. In the known IC it is then possible to omit the auto-zeroing comparator and to generate the ID code from the sign of the effective cell outputs. When the average value is not larger than the absolute value of the offset, the auto-zeroing comparator may be omitted as well. Then, however, only a small number of ID cells will have a sign different from the sign of the constant offset and a larger first subset is required for generating the ID code.

Provided the average value is larger than the absolute value of the offset, it is further advantageous if the identification cells each contain only one electrical device. When the average value is larger than the absolute value of the offset, it is possible to generate an ID code by comparing the parameter value of a single electrical device per ID cell with a standard parameter value. This standard parameter value may be generated, e.g. by one device in the second subset. By virtue thereof, it is possible to save space and costs as compared to situations where there is more than one device per ID cell such as, e.g. in the known IC which has two devices per ID cell.

It is advantageous if the random parametric variations comprise a random distribution of doping atoms in at least a part of the electrical device. It is relatively easy to have increased random parametric variations in the first subset with respect to those in the second subset if the random parametric variations are at least partly due to a random distribution of doping atoms. During manufacturing of the IC the increase of the random parametric variations in the first subset with respect to those in the second subset can be achieved by, e.g. randomly distributed objects which at least partly prevent doping atoms from being implanted in the devices of the ID cells.

In an embodiment, the electrical device having random parametric variations due to a random distribution of doping atoms comprises a transistor. Transistors have electrical device parameters such as, e.g. the threshold voltage which strongly depends on the random distribution of doping atoms. Therefore, it is relatively easy to generate an ID code using these devices.

It is advantageous if the transistor is a MOSFET. This type of transistor can be operated at low voltages and low power.

In an embodiment, the MOSFET comprises a source, a drain, a gate, and a channel, which is situated between the source, the drain and the gate, the channel being electrically insulated from the gate by an oxide, the part of the electrical device having the random distribution of doping atoms comprising the channel. The threshold voltage of a MOSFET is particularly sensitive to the number and the position of the doping atoms in the channel.

It is advantageous if the electrical device comprises an ohmic resistor having a resistance value, which is a function of the random parametric variations. The resistance of an ohmic resistor can be readily measured. There are several ways to increase the first random parametric variations which modify the resistance, as will be described below.

In one embodiment, the ohmic resistor comprises a silicide material and has a shape, the random parametric variations comprising a random distribution of shapes. Usually, a silicide is formed by first depositing polycrystalline silicon, which is subsequently covered by a thin layer of metal atoms such as titanium or tungsten. The polycrystalline silicon and the metal layer are then heated to form a silicide. The geometrical shape of the so-formed silicide depends on the shapes of the polycrystalline silicon and of the metal layer.

The number of deposited metal atoms per unit area is subject to statistical variations which are usually kept as small as possible. The statistical variations in the first subset may have been increased by randomly distributing objects in the area of the first subset, which objects prevent metal atoms from forming silicide. In this way the shape of the silicide and hence the resistance of the ohmic resistor formed by the silicide may have been randomly altered.

In another embodiment, the random parametric variations comprise a random distribution of insulating objects in the ohmic resistor. Usually, the number of these objects is kept as low as possible. According to the invention they have been deliberately introduced to increase the random parametric variations in the first subset, resulting in a larger variation in resistances.

In a variation of this embodiment, the first subset comprises a random number of ID cells each having ohmic resistors comprising a first part and a second part, which is electrically insulated from the first part by the insulating objects. The objects then cause random open circuits in some of the ID cells, which are easy to detect.

The method for manufacturing the IC according to the invention is realized in that means for increasing the random parametric variations in at least a part of the first portion with respect to the random parametric variations in the second portion are applied during at least part of the execution of the step.

It is advantageous if during at least a part of the step of applying the means for increasing the random parametric variations the second portion is covered by a first mask which at least partly prevents an increase of the random parametric variations in the second portion. By covering the second portion of the substrate while, e.g. implanting doping atoms in the first portion and applying means for increasing the random parametric variations, it is possible to selectively introduce random parametric variations in the first portion, which are larger than the random parametric variations in the second portion.

It is advantageous if the step causing random parametric variations comprises a sub-step causing random parametric variations in at least a part of the second portion while the first portion is covered by a second mask which at least partly prevents introducing the random parametric variations in the first portion during the sub-step. In this way the relative difference between the random parametric variations in the first portion and the random parametric variations in the second portion is maximized because the random parametric variations in the first portion are as large as possible and the random parametric variations in the second portion are as small as possible. The latter has the additional advantage that the IC will function reliably.

It is advantageous if the step causing the random parametric variations comprises implanting doping atoms. It is relatively easy to increase the random parametric variations if they are at least partly due to a random distribution of doping atoms.

It is advantageous if the means for increasing the random parametric variations comprise objects randomly distributed over at least a part of the first portion, the objects at least partly preventing doping atoms from being implanted. In this way it is possible to use an apparatus commonly used for doping atom implantation without any further adjustment.

It is advantageous if latex balls are applied as the objects because latex balls are available in well-defined shapes and sizes. They can be easily randomly distributed and they are easily removable by a cleaning agent. Alternatively, a quantity of photoresist may be distributed which is so small that the photoresist does not form a single layer covering the entire surface but leaves some portions of the surface uncovered.

It is advantageous if at least a part of the doping atoms carry a charge when they are implanted, and a deflection unit randomly deflecting the charged doping atoms by applying a random deflection signal is used as the means for increasing the random parametric variations. Charged doping atoms can be deflected by applying an electrical and/or magnetic field. These fields can be controlled by adjusting a voltage and a current, respectively. The voltage source and the current source can be successively connected to a random signal generator to increase the random parametric variations.

These and other aspects of the IC and the method of manufacturing same according to the invention will be further elucidated and described with reference to the drawings, in which:
Fig. 1 is a block diagram of the IC;
Figs. 2A and 2B are schematic diagrams of two embodiments of an ID cell of the IC shown in Fig. 1;
Fig. 3 is a cross-section of a MOSFET shown in Figs. 2A and 2B;
Fig. 4 is a schematic diagram of an embodiment of the load cell of the IC shown in Fig. 1;
Figs. 5A and 5B are top views of the substrate and the mask at two stages in one embodiment of the method of manufacturing;
Figs. 6A and 6B are cross-sections of the substrate according to VIA-VIA and VIB-VIB in Figs 5A and 5B, respectively;
Fig. 7 is a schematic diagram of the ion implantation equipment used in an embodiment of the method; and
Fig. 8 is a cross-section of an embodiment of the IC.

The Figures are not drawn to scale. In the Figures, like reference numerals generally refer to like parts.

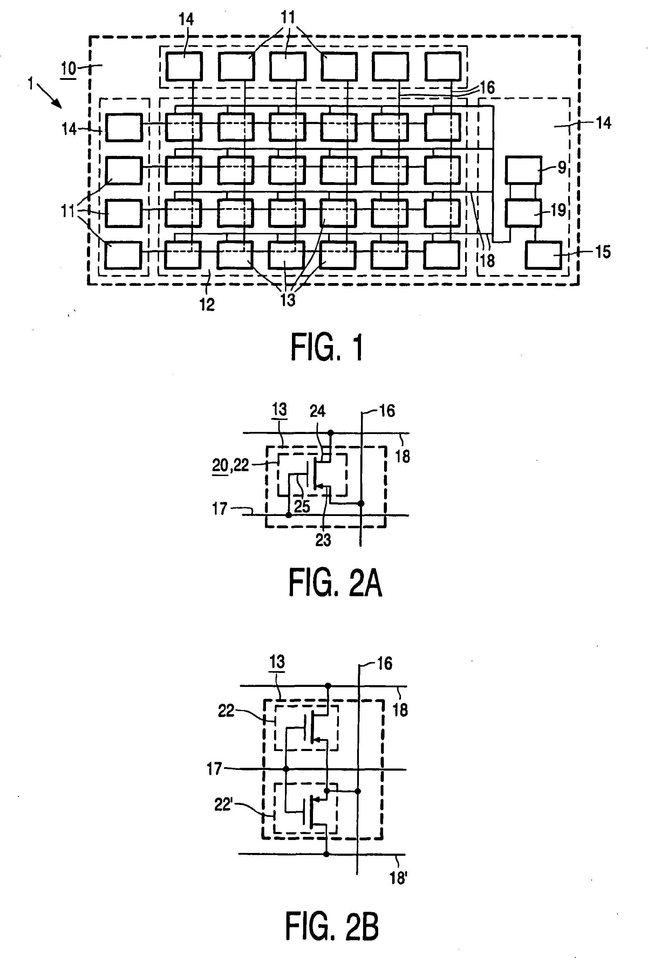

The IC 1, shown in Fig. 1, is equipped with a set of cells 10, which comprises a first subset 12 of ID cells 13. In the embodiment of Fig. 1, the ID cells 13 form a rectangular array of 6 x 4 cells, but the invention is not limited to an IC having an array of this size or shape. The ID cells 13 are connected to column lines 16, row lines 17, and output lines 18. The IC 1 is further equipped with a second subset of cells 14, which comprise access control cells 11 for stimulating a single ID cell 13.

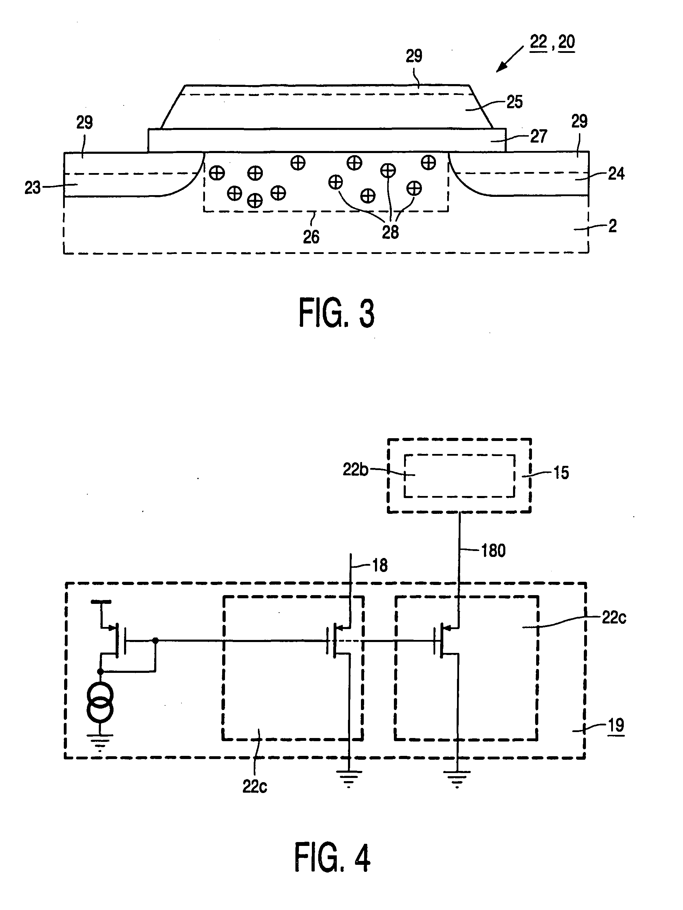

In one embodiment, shown in Fig. 2A, each of the ID cells 13 comprises one electrical device 20, which is a P channel MOSFET 22, shown in Fig. 3. The MOSFET 22 comprises a source 23, a drain 24, a gate 25, and a channel 26, which is situated between the source 23, the drain 24 and the gate 25. The channel 26 is electrically insulated from the gate 25 by an oxide 27. The access control cells 11, which may be, e.g. identical to those of the stimulus circuit shown in Fig. 11 of US-6,161,213, comprise MOSFETs 22a, which are of identical design as MOSFETs 22 of the ID cells 13.

Referring now to Fig. 2A, for each row, the gates 25 are connected to the same row line 17 and for each column, the sources 23 are connected to the same column line 16. For each row, the drains 24 are connected to the same output line 18. The output lines 18 of different rows are mutually electrically connected. To stimulate the MOSFET 22 of a particular ID cell 13, the column line 16 connected to the source 23 of this MOSFET 22 is put on a relatively high voltage by the access control cell 11 of the corresponding column and the row line 17 connected to the gate 25 is provided with an analogous bias voltage by the access control cell 11 of the corresponding row. As a result of this stimulus, MOSFET 22 is driven into saturation and it conducts a current through the drain 24 and the output line 18 connected to it.

The parameter value of the current, which is a device parameter of the MOSFET 22, is a function of random parametric variations. The random parametric variations comprise amongst others a random distribution of doping atoms 28 implanted in the channel 26 of MOSFET 22, as shown in Fig. 3. The amount and the position of the doping atoms 28 is one of the parameters, which determines the parameter value of the current, which flows from the source 23 to the drain 24 via the channel 26 when the MOSFET 22 is stimulated by biasing the gate 25 and putting the source 23 on a relatively high voltage.

Because of the random distribution of the doping atoms 28, two MOSFETs 22 produce two currents having a random difference, even when they are provided with the same stimulus. The random difference between these two currents is used to generate an ID code. To this end, the current of a particular ID cell 13 is compared to the reference current produced by a reference cell 15, which comprises a MOSFET 22b, not shown. The MOSFET 22b, which is identically designed as the MOSFET 22 of the ID cells 13 and the access control cells 11, is provided with the same stimulus as the MOSFET 22 to produce the reference current, which is designed to be identical to the current produced by MOSFET 22 of the ID cells 13.

The current produced by MOSFET 22 and the reference current are terminated in a load cell 19, shown in Fig. 4, which is a simplified version of the load cell of the known IC. The load cell 19 comprises two MOSFETs 22c, which are identically designed as the MOSFET 22 of the ID cells 13 and the access control cells 11. The voltage between the output line 18 and the reference line 180 due to the termination of the current and the reference current are compared by a comparator 9 similar to that of the known IC. The comparator 9 produces a relatively high output voltage when the voltage difference between the output line 18 and the reference line 180 is positive and otherwise a relatively low output voltage. By sequentially addressing the ID cells 13 and recording the output voltage, an ID code is generated.

According to the invention, the ID cells 13 of the first subset 12 have first random parametric variations and the cells 11, 15, 19 of the second subset 14 have second random parametric variations, the first random parametric variations being larger than the second random parametric variations. Methods to manufacture such an IC will be discussed below.

When the IC is manufactured using standard IC technology, the random parametric variations are kept as small as possible and the above-mentioned condition is not met. It is hard then to detect the random differences in the parameter values of the current and to generate the ID code because the MOSFETs 22, 22a, 22b, and 22c all have substantially the same random parametric variations.

To illustrate the resulting difficulties, it should be noted that the reference current produced by MOSFET 22b of the reference cell 15 has a certain random, but fixed offset as compared to the current which should be produced by an ideal MOSFET 22 according to the design. It may happen, for instance, that the reference current is relatively low as compared to most of the currents produced by MOSFET 22 of the ID cells 13. In this case, the ID code does not reflect the random differences among the currents produced by the ID cells 13, but it is mainly determined by the offset. This ID code cannot reliably be used for identifying the IC.

The MOSFETs 22a of the access control cells 11 also have random parametric variations causing fixed, but random differences between the designed output and the actual output. Therefore, the stimuli applied to the ID cells 13 are different as compared to the ideal value. It may happen e.g. that the access control cell 11 of a certain row comprises a MOSFET 22a, which produces a relatively low stimulus as compared to the other MOSFET 22a. All the ID cells 13 of this row will, therefore, have an offset and produce a current, which is low as compared to the reference current. Also in this case the ID code does not reliably reflect the random differences among the currents produced by the ID cells 13, but it is to a large extend determined by the offset due to MOSFET 22a.

The MOSFETs 22c of the load cell 19 also have random parametric variations causing a fixed, but random difference between the designed voltage drop and the actual voltage drop across MOSFET 22c when it is supplied with the reference current. It may happen e.g. that the MOSFET 22c connected to the reference line 180 causes a relatively large voltage drop when it is supplied with the reference current, whereas MOSFET 22c connected to the output line 18 causes a relatively small voltage drop when provided with the same current. Again the ID code does not reliably reflect the random differences among the currents produced by the ID cells 13; it is to a large extend determined by the offset due to MOSFET 22c. According to the invention, the load cell 19, shown in Fig. 4, comprises only one MOSFET 22b connected to output line 18 and reference line 180, respectively, which is simpler than in the known IC. To reduce the offset introduced by the load cell 19, the known IC comprises a combination of four MOSFETs 22b, with the number of MOSFETs 22b connected in series and in parallel being the same.

As the first random parametric variations are larger than the second random parametric variations, it is no longer necessary to use four MOSFETs 22b per output line 18 and 18'. In addition, also the other difficulties discussed above are reduced to a large extent, when the first random parametric variations are larger than the second random parametric variations, because then the chance that the ID code is mainly determined by offset due to MOSFET 22a, 22b, and 22c is reduced.

In one embodiment, the first random parametric variations have been increased with respect to the second random parametric variations to such extent that the average of the absolute values of the random differences among the parameter values of the ID cells 13 are larger than the absolute value of the offsets. This condition implies that the chance that the ID code is mainly determined by offset due to MOSFET 22a, 22b, and 22c is significantly reduced.

In another embodiment, the ID cells 13, shown in Fig. 2B, are identical to those shown in Fig. 4 of US-6,161,213. Each of the ID cells 13 comprises two substantially similar MOSFETs 22 and 22'. The gates of the two MOSFETs 22 and 22' are connected to the same row line 17 and the sources of the two MOSFETs 22 and 22' are connected to the same column line 16. The drains of MOSFETs 22 and 22' are connected to output lines 18 and 18', respectively.

The ID code is generated by comparing the currents on output lines 18 and 18' for each ID cell 13 using the load cell 19 shown in Fig. 4, in which output line 18' is connected to reference line 180. In this embodiment, reference cell 15 is not present. The voltage difference between output lines 18 and 18' is further processed by an error detection element, not shown, in a manner analogous to the processing described in US-6,161,213.

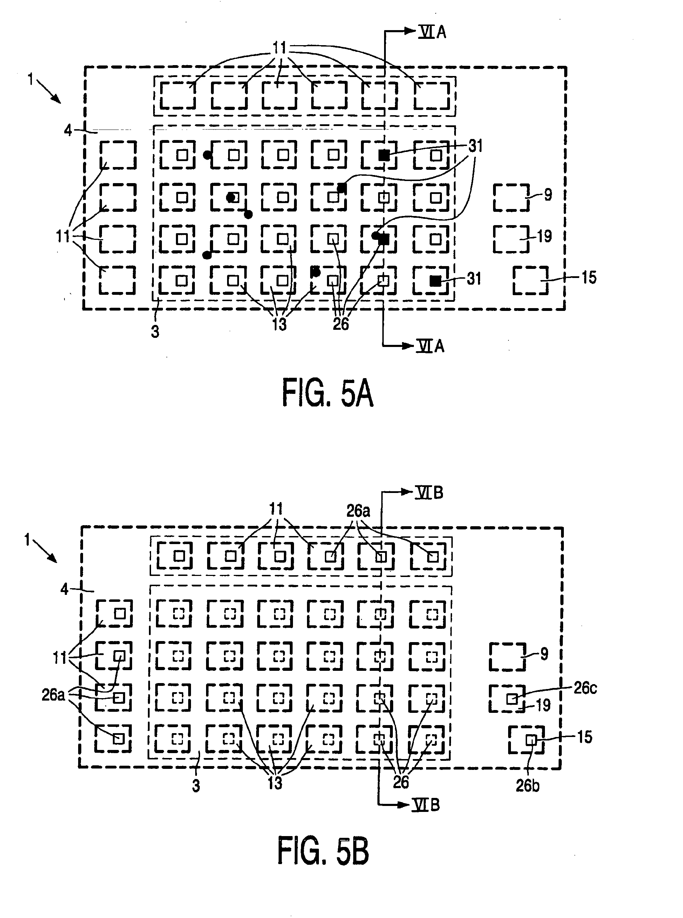

Most steps of the method for manufacturing the IC 1 described above are commonly used in standard IC technology. Analogous to the prior art, the method comprises a step of implanting doping atoms 28 into the channel 26, which causes the cells 11, 13, 15, and 19 to have the random parametric variations. The IC 1, shown in Fig. 1, is integrated in a substrate 2, shown in Figs. 5A and 5B. The substrate 2 has a first portion 3 and a second portion 4 which, after completion of the manufacturing process comprise the first subset 12 and the second subset 14, respectively.

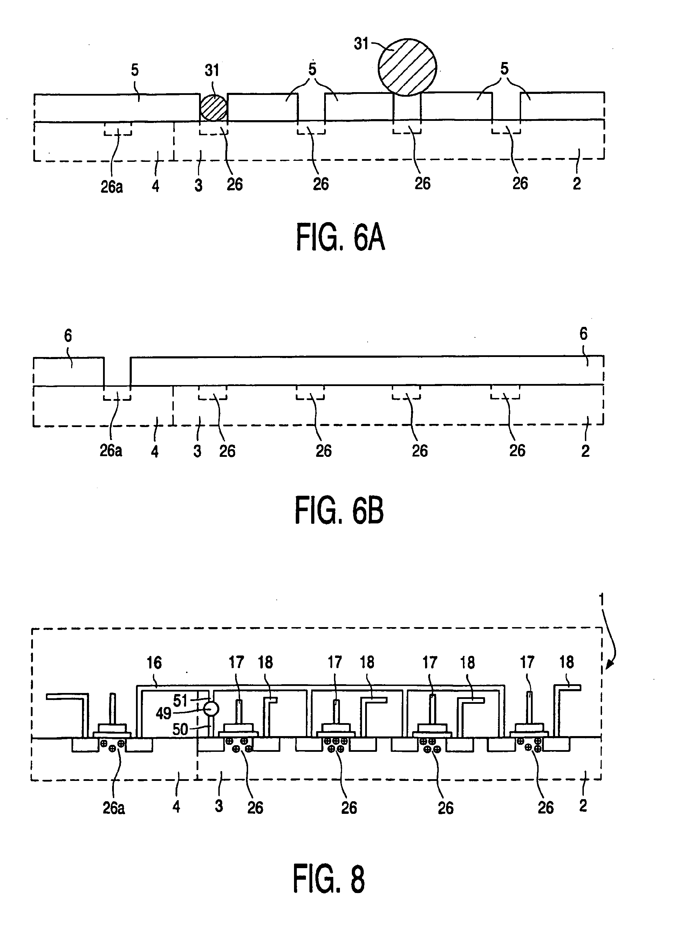

According to the invention, means for increasing the random parametric variations in at least a part of the first portion 3 with respect to the random parametric variations in the second portion 4 are applied. During at least a part of the execution of the step of implanting doping atoms 28, the second portion 4 is covered by a first mask 5, which at least partly prevents doping atoms 28 from being implanted in the second portion 4. The first mask 5, shown in Figs. 5A and 6A, is a resist layer in which openings are made at the positions of the channels 26 of MOSFET 22 of the ID cells 13 by means of photolithography.

Before implanting the doping atoms 28 in the channels 26 in the ID cells 13, objects 31, which may be latex balls, are randomly distributed over at least a part of the first portion 3. It is possible to a certain extent that the objects 31, shown in Fig. 6A, cover some of the openings in the photoresist and thereby at least partly prevent doping atoms 28 from being implanted. The objects 31 are thus applied as the means for increasing the random parametric variations. After implanting the doping atoms 28 in the channels 26 in MOSFET 22, the objects 31 and the first mask 5 are removed.

By photolithography and etching, a second mask 6, shown in Figs. 5B and 6B, is formed, which covers the first portion 3 and at least partly prevents doping atoms 28 from being implanted. In the second mask 6 openings are made at the positions of the channels 26a, 26b and 26c of MOSFETs 22a, 22b, and 22c of the access control cells 11, the reference cell 15, and the load cell 19, respectively, by means of photolithography and etching, and subsequently doping atoms 28 are implanted.

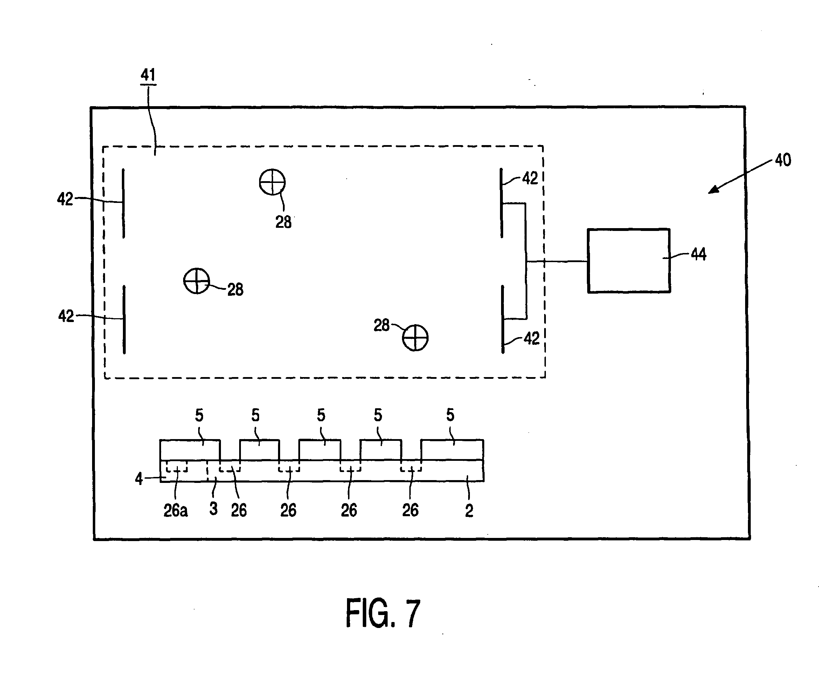

In an alternative embodiment of the method, at least a part of the doping atoms 28 carry a charge when they are implanted. To this end ion implantation equipment 40, well known in the art of IC manufacturing, is used. The ion implantation equipment 40, shown in Fig. 7, comprises a deflection unit 41, which has two quadrupole deflectors 42, each comprising four electrodes, two of which are shown for each quadrupole deflector 42 in Fig. 7. In the normal operating mode, the electrodes 43 are connected to a voltage generator, which is used to scan the beam of charged doping atoms 28 over the substrate 2 in such a way that the doping atoms 28 are implanted as uniformly as possible.

Analogous to the method described above, the second portion 4 is covered by the first mask 5, which has openings at the positions of the channels 26 of MOSFET 22. When performing the step of implanting doping atoms 28, the electrodes 43 are connected to a random signal generator 44, which generates random voltages. The random voltages, which may be added to the voltages used in the normal operating mode, randomly deflect the doping atoms 28, as a result of which the doping atoms 28 are not implanted uniformly. Again analogous to the method described above, the first mask 5 is removed in.

After depositing the second mask 6, the doping atoms 28 are implanted in the channels 26a, 26b, and 26c of MOSFET 22a, 22b, and 22c using the ion equipment 40 in the normal operating mode. As a result the random parametric variations in the first portion 3 are increased with respect to the random parametric variations in the second portion 4.

In another embodiment the IC 1 comprises the ID cells 13, shown in Fig. 2A, each having a MOSFET 22, shown in Fig. 3. The source 23, the drain 24, and the gate 25 of each MOSFET 22, 22a, 22b, and 22c comprise silicide 29 shown in Fig. 3. The silicide, which is titanium silicide, is connected to a column line 16, a row line 17 and an output line 18, respectively, shown in Fig. 2A. The silicide 29 is an ohmic resistor with a resistance whose value is a function of random parametric variations. The resistance of the silicide 29 is in particular a function of the shape of the silicide 29.

In standard IC technology, the silicide 29 is formed by providing silicon with a layer of a metal such as, e.g. titanium, and heating up the silicon to form a silicide. The shape of the silicide 29 depends amongst others on the amount of metal present. This amount is subjected to random parametric variations when the metal is deposited. In standard IC technology, these random parametric variations are kept as small as possible.

According to one embodiment of the invention, the random parametric variations in the thickness of the metal layer are deliberately increased in the first portion 3 as compared to the second portion 4. To this end, a resist layer as a first mask 5', not shown, is applied, which covers the second portion 4 and thereby prevents the metal layer from being deposited in the second portion 4. In the first mask 5' openings are made at the positions of the source 23 and the drain 24 of MOSFET 22 of the ID cells 13 by means of photolithography and etching.

Subsequently, objects 31 are randomly distributed to cover some of the openings in the first mask 5', the metal layer is deposited and the substrate 2 is heated to form a silicide 29. At the random positions of the objects 31 coinciding with the openings in the first mask 5', a smaller amount of silicide 29 is formed and these ID cells 13 will produce a reduced current because of the larger resistance of the silicide 29. Analogous to the method described above, the first mask 5' is removed.

The source 23 and drain 24 of the MOSFET 22a, 22b and 22c are provided with a silicide 29 using standard IC technology.

In a variation of this embodiment, shown in Fig. 8, insulating objects 49 are distributed over a part of the first portion 3 after the silicide 29, not shown in Fig. 8, has been formed, but before the source 23, the drain 24, and the gate 25 of MOSFET 22 are contacted to column lines 16, row lines 17 and output lines 18, which form ohmic resistors. Some of the ohmic resistors comprise a first part 50 and a second part 51, which is electrically insulated from the first part 50 by the insulating objects 49 and, therefore, the resistance of these ohmic resistors is a function of large random parametric variations as compared to the ohmic resistors in the second portion 4. Other ohmic resistors, not shown, may comprise insulating objects 49, which reduce the conductivity of the ohmic resistor, but do not cause an open circuit.

The integrated circuit comprises a set of cells, each of the cells comprises an electrical device with a device parameter whose parameter value is a function of random parametric variations. The set of cells comprises a first subset of identification cells with first random parametric variations, and a second subset of cells, which are able to generate an identification code by measuring the random differences between the parameter values of the identification cells. According to the invention the cells of the second subset have second random parametric variations, which are smaller than the first random parametric variations, thereby making the generation of the identification code relatively easy.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements.

### List of numerals

| | |
|---|---|
| integrated circuit 1 | |
| substrate 2 | |
| first portion 3 | |
| second portion 4 | |
| first mask 5 and 5' | |
| second mask 6 and 6' | |
| comparator 9 | |
| set of cells 10 | |
| access control cells 11 | |
| first subset 12 | |
| identification cell 13 | |
| second subset of cells 14 | |
| reference cell 15 | |
| column line 16 | |
| row lines 17 | |
| output lines 18 and 18' | |
| load cell 19 | |
| electrical device 20 | |
| MOSFET 22 (ID cell), MOSFET 22a (access control cell), MOSFET 22b (reference cell),MOSFET 22c (load cell), MOSFET 22' | |
| source 23 | |
| drain 24 | |
| gate 25 | |
| channel 26, 26a, 26b, 26c | |
| oxide 27 | |
| doping atom 28 | |
| silicide 29 | |
| objects 31 | |
| ion implantation equipment 40 | |
| deflection unit 41 | |
| quadrupole deflector 42 | |
| random signal generator 44 | |
| insulating object 49 | |
| first part 50 | |
| second part 51 | |
| reference line 180 | |

## Claims

1. An integrated circuit (1) comprising a set of cells (10), each cell (11, 13, 15, 19) comprising an electrical device (20), each electrical device having a device parameter with a parameter value which is a function of random parametric variations, the set of cells (10) comprising:
- a first subset (12) of identification cells (13); and
- a second subset (14) of cells (11, 15,19) for generating an identification code by sequentially comparing, making use of cells of the second subset (11, 19), the parameter values of electrical devices of the identification cells (13) to the parameter value of the electrical device of a reference cell (15), wherein the electrical devices are identically designed, and wherein the electrical devices of the first subset of identification cells (13) have first random parametric variations and the electrical devices of the cells (11, 15, 19) of the second subset (14) have second random parametric variations, the first random parametric variations being larger than the second random parametric variations.

2. An integrated circuit (1) as claimed in Claim 1, wherein
- the first random parametric variations cause random differences among the parameter values of the electrical devices of the identification cells (13), the random differences each having an absolute value, the absolute values having an average value; and
- the second random parametric variations cause an offset in the parameter values of the electrical devices of the identification cells (13), the offset having an absolute value, the average value being larger than the absolute value of the offset.

3. An integrated circuit (1) as claimed in Claim 2, wherein the identification cells (13) each contain only one electrical device (20).

4. An integrated circuit (1) as claimed in Claim 1 wherein the random parametric variations comprise a random distribution of doping atoms (28) in at least a part of the electrical device (20).

5. An integrated circuit (1) as claimed in Claim 4, wherein the electrical device (20) comprises a metal oxide semiconductor field effect transistor (22) comprising a source (23), a drain (24), a gate (25), and a channel (26), which is situated between the source (23), the drain (24) and the gate (25), the channel (26) being electrically insulated from the gate (25) by an oxide (27), the part of the electrical device (20) having the random distribution of doping atoms comprising the channel (26).

6. An integrated circuit (1) as claimed in Claim 1, wherein the electrical device (20) comprises an ohmic resistor having a resistance value, which is a function of the random parametric variations.

7. An integrated circuit (1) as claimed in Claim 6, wherein the ohmic resistor comprises a silicide material and has a shape, the random parametric variations comprising a random distribution of shapes.

8. An integrated circuit (1) as claimed in Claim 6, wherein the random parametric variations comprise a random distribution of insulating objects (49) in the ohmic resistor.

9. An integrated circuit (1) as claimed in Claim 8, wherein the first subset (12) comprises a number of identification cells (13) each having ohmic resistors comprising a first part (50) and a second part (51), which is electrically insulated from the first part by the insulating objects (49).

10. A method for manufacturing an integrated circuit (1) as claimed in Claim 1, the integrated circuit (1) comprising a substrate (2) and a set of cells (10), each cell (11, 13, 15, 19) comprising an electrical device (20), each electrical device having a device parameter with a parameter value which is a function of random parametric variations, the substrate (2) comprising a first portion (3) and a second portion (4), the method comprising a step which causes the electrical devices of the cells (11, 13, 15, 19) to have the random parametric variations, wherein means for increasing the random parametric variations in at least a part of the first portion (3) with respect to the random parametric variations in the second portion (4) are applied during at least part of the execution of said step.

11. A method as claimed in Claim 10, wherein during at least a part of the step of applying the means for increasing the random parametric variations the second portion (4) is covered by a first mask (5) which at least partly prevents an increase of the random parametric variations in the second portion (4).

12. A method as claimed in Claim 11, wherein the step causing random parametric variations comprises a sub-step causing random parametric variations in at least a part of the second portion (4) while the first portion (3) is covered by a second mask (6) which at least partly prevents introducing the random parametric variations in the first portion (3) during the sub-step.

13. A method as claimed in Claim 10, wherein the step causing the random parametric variations comprises implanting doping atoms (28).

14. A method as claimed in Claim 13, wherein the means for increasing the random parametric variations comprise objects (31) randomly distributed over at least a part of the first portion (3), the objects (31) at least partly preventing doping atoms (28) from being implanted.

15. A method as claimed in Claim 13, wherein at least a part of the doping atoms (28) carry a charge when they are implanted and a deflection unit (41) randomly deflecting the charged doping atoms by applying a random deflection signal is used as the means for increasing the random parametric variations.

## Patentansprüche

1. Ein integrierter Schaltkreis (1) aufweisend einen Satz von Zellen (10), wobei jede Zelle (11, 13, 15, 19) eine elektrische Vorrichtung (20) aufweist, wobei jede elektrische Vorrichtung einen Vorrichtungsparameter mit einem Parameterwert hat, welcher eine Funktion von zufälligen parametrischen Variationen ist, wobei der Satz von Zellen (10) aufweist:
eine erste Untermenge (12) von Identifikationszellen (13); und
eine zweite Untermenge (14) von Zellen (11, 15, 19) zum Generieren eines Identifikationscodes durch sequentielles Vergleichen, unter Zuhilfenahme von Zellen der zweiten Untermenge (11, 19), der Parameterwerte der elektronischen Vorrichtungen von den Identifikationszellen (13) mit dem Parameterwert der elektronischen Vorrichtung von einer Referenzzelle (15), wobei die elektronischen Vorrichtungen identisch designt sind, und wobei die elektronischen Vorrichtungen der ersten Untermenge von Identifikationszellen (13) erste zufällige parametrische Variationen haben und wobei die elektronischen Vorrichtungen der Zellen (11, 15, 19) der zweiten Untermenge (14) zweite zufällige parametrische Variationen haben, wobei die ersten zufälligen parametrischen Variationen größer als die zweiten zufälligen parametrischen Variationen sind.

2. Ein integrierter Schaltkreis (1) wie in Anspruch 1 beansprucht, wobei
die ersten zufälligen parametrischen Variationen zufällige Unterschiede unter den Parameterwerten der elektronischen Vorrichtungen von den Identifikationszellen (13) verursachen, wobei die zufälligen Unterschiede jeweils einen absoluten Werten haben, wobei die absoluten Werte einen Durchschnittswert haben; und
die zweiten zufälligen parametrischen Variationen einen Offset in den Parameterwerten der elektronischen Vorrichtungen der Identifikationszellen (13) verursachen, wobei der Offset einen absoluten Wert hat, wobei der Durchschnittswert größer als der absolute Wert des Offsets ist.

3. Ein integrierter Schaltkreis (1) wie in Anspruch 2 beansprucht, wobei die Identifikationszellen (13) jeweils nur eine elektronische Vorrichtung (20) enthalten.

4. Ein integrierter Schaltkreis (1) wie in Anspruch 1 beansprucht, wobei die zufälligen parametrischen Variationen eine zufällige Verteilung dotierenden Atome (28) in zumindest einem Teil der elektronischen Vorrichtung aufweisen.

5. Ein integrierter Schaltkreis (1) wie in Anspruch 4 beansprucht, wobei die elektronische Vorrichtung (20) einen Metalloxid Halbleiter Feldeffekttransistor (22) aufweist, welcher eine Source (23), eine Drain (24), ein Gate (25) und einen Kanal (26) aufweist, welcher sich zwischen der Source (23), der Drain (24) und dem Gate (25) befindet, wobei der Kanal (26) von dem Gate (25) mittels eines Oxides (27) elektrisch isoliert ist, wobei der Teil der elektronischen Vorrichtung (20) der die zufällige Verteilung von dotierenden Atomen hat, den Kanal (26) aufweist.

6. Ein integrierter Schaltkreis (1) wie in Anspruch 1 beansprucht, wobei die elektronische Vorrichtung (20) einen ohmschen Widerstand aufweist, welcher einen Widerstandswert hat, welcher eine Funktion der zufälligen parametrischen Variationen ist.

7. Ein integrierter Schaltkreis (1) wie in Anspruch 6 beansprucht, wobei der ohmsche Widerstand ein Silicid-Material aufweist und eine Form hat, wobei die zufälligen parametrischen Variationen eine zufällige Verteilung von Formen aufweisen.

8. Ein integrierter Schaltkreis (1) wie in Anspruch 6 beansprucht, wobei die zufälligen parametrischen Variationen eine zufällige Verteilung von isolierenden Objekten (49) in dem ohmschen Widerstand aufweisen.

9. Ein integrierter Schaltkreis (1) wie in Anspruch 8 beansprucht, wobei die erste Untermenge (12) eine Anzahl von Identifikationszellen (13) aufweist, wobei jede ohmsche Widerstände hat, welche einen ersten Teil (50) und einen zweiten Teil (51), welcher von dem ersten Teil mittels der isolierenden Objekte (49) elektrisch isoliert ist, aufweisen.

10. Ein Verfahren zur Herstellung eines integrierten Schaltkreises (1) wie in Anspruch 1 beansprucht, wobei
der integrierte Schaltkreis (1) ein Substrat (2) und einen Satz Zellen (10) aufweist, wobei jede Zelle (11, 13, 15, 19) eine elektrische Vorrichtung (20) aufweist, wobei jede elektrische Vorrichtung einen Vorrichtungsparameter mit einem Parameterwert hat, welcher eine Funktion von zufälligen parametrischen Variationen ist, wobei das Substrat (2) einen ersten Teil (3) und einen zweiten Teil (4) aufweist, wobei
das Verfahren einen Schritt aufweist, welcher die elektrischen Vorrichtungen der Zellen (11, 13, 15, 19) veranlasst, zufällige parametrische Variationen zu haben, wobei ein Mittel zum Zunehmen der zufälligen parametrischen Variationen in zumindest einem Teil des ersten Teiles (3) in Bezug auf die zufälligen parametrischen Variationen in dem zweiten Teil (4) während zumindest einen Teiles der Ausführung dieses Schrittes angewandt wird.

11. Ein Verfahren wie in Anspruch 10 beansprucht, wobei
während zumindest eines Teiles des Schrittes des Anwendens des Mittels zum Zunehmen der zufälligen parametrischen Variationen der zweite Teil (4) mittels einer ersten Maske (5) bedeckt wird, welche zumindest teilweise eine Zunahme der zufälligen parametrischen Variationen in dem zweiten Teil (4) verhindert.

12. Ein Verfahren wie in Anspruch 11 beansprucht, wobei
der Schritt, welcher zufällige parametrische Variationen verursacht, einen Unterschritt aufweist, welcher zufällige parametrische Variationen in zumindest einem Teil des zweiten Teiles (4) verursacht, während der erste Teil (3) mittels einer zweiten Maske (6) bedeckt wird, welche zumindest teilweise ein Einführen der zufälligen parametrischen Variationen in dem ersten Teil (3) während des Unterschrittes verhindert.

13. Ein Verfahren wie in Anspruch 10 beansprucht, wobei
der Schritt, welcher die zufälligen parametrischen Variationen verursacht, ein Einbetten von dotierenden Atomen (28) aufweist.

14. Ein Verfahren wie in Anspruch 13 beansprucht, wobei das Mittel zum Zunehmen der zufälligen parametrischen Variationen Objekte (31) aufweist, welche zufällig über zumindest einen Teil des ersten Teiles (3) verteilt sind, wobei die Objekte (31) zumindest teilweise dotierende Atome (28) daran hindern eingebettet zu werden.

15. Ein Verfahren wie in Anspruch 13 beansprucht, wobei zumindest ein Teil der dotierenden Atome (28) eine Ladung führt, wenn sie eingebettet werden, und eine Ablenkeinheit (41), welche zufällig die geladenen dotierenden Atome mittels Anwendens eines zufälligen Ablenksignales ablenkt, genutzt wird als das Mittel zum Zunehmen der zufälligen parametrischen Variationen.

## Revendications

1. Circuit intégré (1) comprenant un ensemble de cellules (10), chaque cellule (11, 13, 15, 19) comprenant un dispositif électrique (20), chaque dispositif électrique étant doté d'un paramètre de dispositif avec une valeur de paramètre qui est une fonction de variations paramétriques aléatoires, l'ensemble de cellules (10) comprenant :
- un premier sous-ensemble (12) de cellules d'identification (13) ; et
- un deuxième sous-ensemble (14) de cellules (11, 15, 19) destiné à générer un code d'identification au moyen d'une comparaison séquentielle, en utilisant des cellules du deuxième sous-ensemble (11, 19), des valeurs de paramètre des dispositifs électriques des cellules d'identification (13) avec la valeur de paramètre du dispositif électrique d'une cellule de référence (15), les dispositifs électriques étant conçus de manière identique, les dispositifs électriques du premier sous-ensemble de cellules d'identification (13) présentant des premières variations paramétriques aléatoires et les dispositifs électriques des cellules (11, 15, 19) du deuxième sous-ensemble (14) présentant des deuxièmes variations paramétriques aléatoires, les premières variations paramétriques aléatoires étant plus grandes que les deuxièmes variations paramétriques aléatoires.

2. Circuit intégré (1) tel que revendiqué dans la revendication 1, dans lequel :
- les premières variations paramétriques aléatoires provoquent des différences aléatoires parmi les valeurs de paramètre des dispositifs électriques des cellules d'identification (13), les différences aléatoires ayant chacune une valeur absolue, et les valeurs absolues ayant une valeur moyenne ; et
- les deuxièmes variations paramétriques aléatoires provoquent un décalage dans les valeurs de paramètre des dispositifs électriques des cellules d'identification (13), le décalage ayant une valeur absolue, et la valeur moyenne étant plus grande que la valeur absolue du décalage.

3. Circuit intégré (1) tel que revendiqué dans la revendication 2, dans lequel les cellules d'identification (13) ne contiennent chacune qu'un seul dispositif électrique (20).

4. Circuit intégré (1) tel que revendiqué dans la revendication 1, dans lequel les variations paramétriques aléatoires comprennent une distribution aléatoire d'atomes de dopage (28) dans une partie au moins du dispositif électrique (20).

5. Circuit intégré (1) tel que revendiqué dans la revendication 4, dans lequel le dispositif électrique (20) comprend un transistor à effet de champ à semiconducteur à oxyde métallique (22) comprenant une source (23), un drain (24), une grille (25), ainsi qu'un canal (26), qui est situé entre la source (23), le drain (24) et la grille (25), le canal (26) étant isolé électriquement de la grille (25) par un oxyde (27), et la partie du dispositif électrique (20) qui a la distribution aléatoire d'atomes de dopage comprenant le canal (26).

6. Circuit intégré (1) tel que revendiqué dans la revendication 1, dans lequel le dispositif électrique (20) comprend une résistance ohmique ayant une valeur de résistance qui est une fonction des variations paramétriques aléatoires.

7. Circuit intégré (1) tel que revendiqué dans la revendication 6, dans lequel la résistance ohmique comprend un matériau à base de siliciure et présente une forme, les variations paramétriques aléatoires comprenant une distribution aléatoire de formes.

8. Circuit intégré (1) tel que revendiqué dans la revendication 6, dans lequel les variations paramétriques aléatoires comprennent une distribution aléatoire d'objets isolants (49) dans la résistance ohmique.

9. Circuit intégré (1) tel que revendiqué dans la revendication 8, dans lequel le premier sous-ensemble (12) comprend un certain nombre de cellules d'identification (13) ayant chacune des résistances ohmiques qui comprennent une première partie (50) et une deuxième partie (51), celle-ci étant isolée électriquement de la première partie par les objets isolants (49).

10. Procédé de fabrication d'un circuit intégré (1) tel que revendiqué dans la revendication 1, le circuit intégré (1) comprenant un substrat (2) et un ensemble de cellules (10), chaque cellule (11, 13, 15, 19) comprenant un dispositif électrique (20), chaque dispositif électrique étant doté d'un paramètre de dispositif avec une valeur de paramètre qui est une fonction de variations paramétriques aléatoires, le substrat (2) comprenant une première partie (3) et une deuxième partie (4), le procédé comprenant une étape qui a pour effet que les dispositifs électriques des cellules (11, 13, 15, 19) présentent les variations paramétriques aléatoires, dans laquelle des moyens pour augmenter les variations paramétriques aléatoires dans une fraction au moins de la première partie (3) par rapport aux variations paramétriques aléatoires dans la deuxième partie (4) sont mis en oeuvre pendant une partie au moins de l'exécution de ladite étape.

11. Procédé tel que revendiqué dans la revendication 10, dans lequel, pendant une partie au moins de l'étape de mise en oeuvre des moyens pour augmenter les variations paramétriques aléatoires, la deuxième partie (4) est couverte par un premier masque (5) qui empêche au moins partiellement une augmentation des variations paramétriques aléatoires dans la deuxième partie (4).

12. Procédé tel que revendiqué dans la revendication 11, dans lequel l'étape qui a pour effet les variations paramétriques aléatoires comprend une sous-étape provoquant des variations paramétriques aléatoires dans une partie au moins de la deuxième partie (4), tandis que la première partie (3) est couverte par un deuxième masque (6) qui empêche au moins partiellement l'introduction des variations paramétriques aléatoires dans la première partie (3) pendant la sous-étape.

13. Procédé tel que revendiqué dans la revendication 10, dans lequel l'étape qui a pour effet les variations paramétriques aléatoires comprend une implantation d'atomes de dopage (28).

14. Procédé tel que revendiqué dans la revendication 13, dans lequel les moyens pour augmenter les variations paramétriques aléatoires comprennent des objets (31) répartis de manière aléatoire au-dessus d'une partie au moins de la première partie (3), les objets (31) empêchant au moins partiellement l'implantation des atomes de dopage (28).

15. Procédé tel que revendiqué dans la revendication 13, dans lequel une partie au moins des atomes de dopage (28) porte une charge quand ils sont implantés, et une unité de déviation (41) déviant de manière aléatoire les atomes de dopage chargés par application d'un signal de déviation aléatoire est utilisée en tant que moyens pour augmenter les variations paramétriques aléatoires.
